# DEMANDE DE BREVET EUROPEEN

(11) **EP 3 826 054 A1**
(43) Date de publication de la demande: **26.05.2021**
(21) Numéro de dépôt: 20209370.4
(22) Date de dépôt: 24.11.2020
(51) Int. Cl.: H01L 23/522, H01L 23/64, H01L 23/66, H01L 49/02, H01F 17/00, H01F 41/04, H01L 27/12

(54) **DISPOSITIF ÉLECTRONIQUE INTEGRÉ COMPRENANT UNE BOBINE ET PROCÉDÉ DE FABRICATION D'UN TEL DISPOSITIF**

(30) Priorité: 25.11.2019 FR 1913151
(71) Demandeur: Commissariat à l'Energie Atomique et aux Energies Alternatives, 75015 Paris (FR)
(72) Inventeur: COLINGE, Jean-Pierre, 38054 GRENOBLE CEDEX 09 (FR)
(74) Mandataire: Cabinet Camus Lebkiri

(57) **Abrégé**

L'invention concerne un dispositif électronique (30) comprenant :
- un substrat (21) ;
- une couche de matériau semi-conducteur poreux (22) disposée sur le substrat (21) ;
- un premier matériau à haute perméabilité magnétique (25) disposé à l'intérieur des pores d'une première portion (22a) de la couche de semi-conducteur poreux (22), la première portion (22) de la couche de matériau semi-conducteur poreux (22) imprégnée du premier matériau à haute perméabilité magnétique (25) formant un première couche magnétique séparée du substrat (21) par une deuxième portion (22b) de la couche de matériau semi-conducteur poreux (22) ; et
- une bobine (23) disposée sur la première couche magnétique.

## Description

### DOMAINE TECHNIQUE

La présente invention est relative aux dispositifs électroniques intégrés fabriqués à partir d'un substrat en matériau semi-conducteur, et plus particulièrement aux self-inductances dites sur puce (« on-chip inductors » en anglais) utilisées pour des applications radiofréquences.

### ÉTAT DE LA TECHNIQUE

Différents types de substrat peuvent être utilisés pour fabriquer des circuits électroniques intégrés. Le substrat est généralement choisi en fonction du type de circuit à fabriquer : circuits radiofréquences (RF), circuits logiques à base de transistors MOS, capteurs d'images...

Parmi les substrats d'intérêt, on peut citer la structure multicouche silicium sur isolant ou SOI (pour « Silicon On Insulator » en anglais). La structure multicouche SOI comprend successivement une couche de support en silicium, une couche électriquement isolante, généralement une couche d'oxyde dite enterrée (ou couche BOX, pour « buried oxide layer » en anglais), et un film mince en silicium monocristallin, aussi appelé couche active. La couche active est ainsi nommée car elle est destinée à recevoir des composants actifs, typiquement des transistors MOS (acronyme de « Metal Oxide Semiconductor »). Le canal de conduction des transistors MOS est formé dans la couche active.

La structure SOI offre la possibilité de fabriquer des transistors complètement déplétés ou FDSOI (« Fully Depleted SOI »). Pour qu'un transistor MOS puisse fonctionner en mode complètement déplété, l'épaisseur du film de silicium doit être suffisamment faible pour que la zone de déplétion du transistor atteigne la couche d'oxyde enterrée. Les principaux avantages de technologie FDSOI sont l'amélioration du contrôle électrostatique du canal par la grille du transistor, minimisant ainsi les effets de canaux courts, et la possibilité de modifier la tension de seuil des transistors en polarisant des jonctions se trouvant sous la couche d'oxyde enterrée.

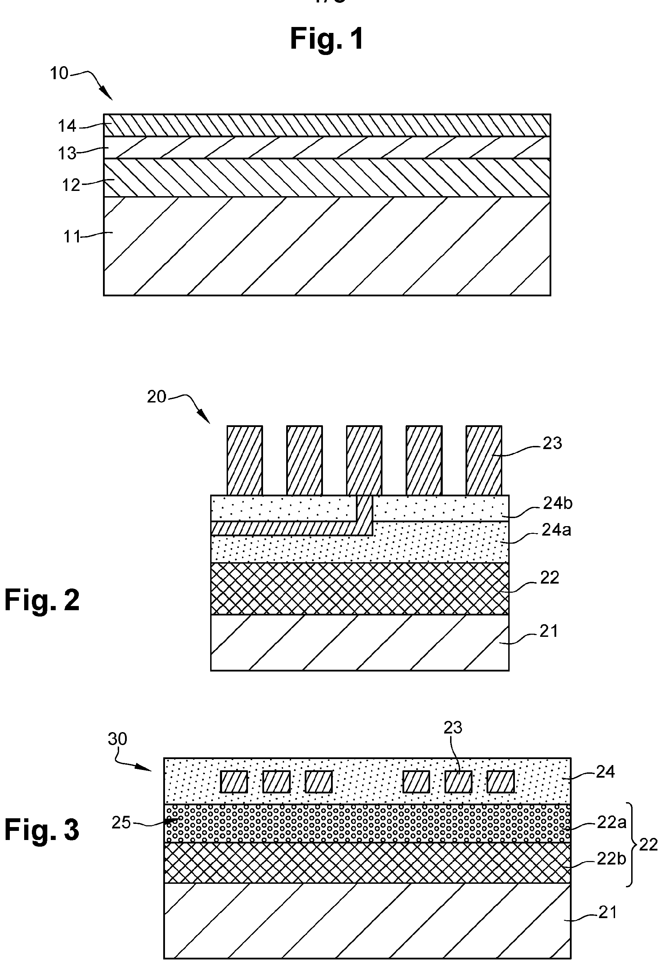

[Fig. 1] : La figure 1 montre une autre structure multicouche 10, dérivée de la structure SOI et couramment utilisée pour la fabrication de circuits intégrés RF, tels que les modules d'émission-réception de signaux RF intégrés dans les téléphones portables (modules dits « front-end »).

Cette structure multicouche 10, appelée « TR-SOI », comprend successivement une couche de support 11 en silicium de haute résistivité, une couche riche en pièges (« trap-rich layer ») 12, une couche d'oxyde enterrée 13 et une couche active 14 en silicium monocristallin. La couche riche en pièges 12 empêche le phénomène de conduction parasite à l'interface entre la couche de support 11 et la couche d'oxyde enterrée 13, ce phénomène étant habituellement causé par des électrons libres qui s'accumulent à l'interface sous l'effet des charges positives fixes contenues dans la couche d'oxyde enterrée 13. Grâce à la couche riche en pièges 12, les électrons sont piégés et ne peuvent plus circuler. La résistivité effective de la couche de support 11 est ainsi augmentée par rapport à une structure multicouche dépourvue de couche riche en pièges (structure appelée « HR-SOI »). La couche riche en pièges 12 peut être constituée de silicium polycristallin. Les pièges sont situés aux joins de grain du silicium polycristallin.

La structure TR-SOI 10 améliore grandement les performances RF des circuits intégrés fabriqués à partir de cette structure, notamment en termes de linéarité et de diaphonie. Les éléments passifs (inductances, capacités...) formés au-dessus de la couche active 14 bénéficient quant à eux d'un meilleur facteur de qualité.

Les inductances ou bobines jouent un rôle prépondérant dans les circuits intégrés RF. Elles interviennent dans de nombreuses fonctions, telles que l'adaptation d'impédance, le filtrage et l'amplification des signaux RF. Elles occupent une grande partie de la superficie des circuits.

[Fig. 2] : En référence à la figure 2, le document [« High-Performance Inductors Integrated on Porous Silicon », IEEE Electron Device Letters, Vol.26, No.2, 2005] décrit un dispositif électronique intégré 20 comprenant un substrat 21 en silicium fortement dopé de type p (et donc de faible résistivité), une couche de silicium poreux 22 disposée sur le substrat 21 et une bobine planaire 23 enroulée en spirale et disposée sur la couche de silicium poreux 22. La couche de silicium poreux 22 est formée par anodisation d'une région superficielle du substrat 21. Des couches diélectriques 24a-24b séparent la bobine 23 de la couche de silicium poreux 22.

La couche de silicium poreux 22 améliore le facteur de qualité Q (en réduisant notamment les pertes par effet Joule dues aux courants de Foucault) et la fréquence de résonnance fᵣ de la bobine 23. En revanche, elle n'a aucun impact sur l'inductance (série) Ls de la bobine. D'après le document, une bobine d'inductance élevée ne peut donc être obtenue qu'en augmentant les dimensions de la bobine (y compris le nombre de spires) et donc la superficie (ou emprise) de la bobine. Il en résulte une augmentation de la taille du circuit RF dans lequel la bobine 23 est intégrée.

### RÉSUMÉ DE L'INVENTION

L'invention a pour but d'améliorer les performances d'une inductance sur puce sans toutefois augmenter son encombrement.

Selon un premier aspect de l'invention, on tend vers cet objectif en prévoyant un dispositif électronique intégré comprenant :
- un substrat ;
- une couche de matériau semi-conducteur poreux disposée sur le substrat ;
- un premier matériau à haute perméabilité magnétique disposé à l'intérieur des pores d'une première portion de la couche de semi-conducteur poreux, la première portion de la couche de matériau semi-conducteur poreux imprégnée du premier matériau à haute perméabilité magnétique formant un première couche magnétique séparée du substrat par une deuxième portion de la couche de matériau semi-conducteur poreux ; et
- une bobine disposée sur la première couche magnétique.

La perméabilité magnétique (µ) caractérise la faculté d'un matériau à modifier un champ magnétique, c'est-à-dire à modifier/diriger les lignes de champ magnétique. On appelle ci-dessus « matériau à haute perméabilité magnétique » un matériau ayant une perméabilité magnétique supérieure à 100 x µ₀, où µ₀ est la perméabilité du vide (µ₀ = 4π x 10⁻⁷ H/m), soit une perméabilité magnétique supérieure à celle de l'acier au carbone.

La première couche magnétique, comprenant le matériau semi-conducteur poreux et le premier matériau à haute perméabilité magnétique, augmente l'inductance de la bobine en canalisant les lignes de champ magnétique. L'introduction du premier matériau à haute perméabilité magnétique dans une portion de la couche de matériau semi-conducteur poreux évite de superposer un noyau magnétique à la couche de matériau semi-conducteur poreux, limitant ainsi l'encombrement du dispositif électronique intégré. La deuxième portion de la couche de matériau semi-conducteur poreux forme une couche de confinement des électrons, qui limite fortement les courants de Foucault dans le substrat, et par conséquent les pertes résistives par effet Joule.

De préférence, la bobine est plane et enroulée en spirale.

Dans un mode de réalisation du dispositif électronique intégré, le premier matériau à haute perméabilité magnétique est en outre disposé à l'intérieur des pores d'une troisième portion de la couche de matériau semi-conducteur poreux et d'une quatrième portion de la couche de matériau semi-conducteur poreux, la troisième portion étant située au centre de la bobine et la quatrième portion étant située à la périphérie de la bobine.

Dans un autre mode de réalisation, le dispositif électronique intégré comprend en outre une deuxième couche magnétique disposée sur la bobine, la deuxième couche magnétique comprenant un deuxième matériau à haute perméabilité magnétique.

Selon un développement de ce mode de réalisation, le premier matériau à haute perméabilité magnétique et le deuxième matériau à haute perméabilité magnétique sont identiques.

Le dispositif électronique intégré selon le premier aspect de l'invention peut également présenter une ou plusieurs des caractéristiques ci-dessous, considérées individuellement ou selon toutes les combinaisons techniquement possibles :
- les pores de la deuxième portion sont dépourvus de matériau électriquement conducteur ;
- les pores de la deuxième portion sont vides ou remplis d'air ;
- la couche de matériau semi-conducteur poreux et la bobine sont supportées par une première région du substrat, le dispositif comprenant en outre un composant actif, tel qu'un transistor à grille arrière, supporté par une deuxième région du substrat, distincte de la première région ;
- la couche de matériau semi-conducteur poreux présente une épaisseur comprise entre 0,2 µm et 2 µm ;
- la deuxième portion de la couche de matériau semi-conducteur poreux présente une épaisseur comprise entre 10 nm et 1 µm ;
- le substrat est en un matériau semi-conducteur de haute résistivité ; et
- le matériau semi-conducteur poreux est du silicium poreux ou un alliage silicium-germanium poreux.

Un deuxième aspect de l'invention concerne un procédé de fabrication d'un dispositif électronique intégré. Ce procédé de fabrication comprenant les étapes suivantes :
- former une couche de matériau semi-conducteur poreux sur un substrat ;
- former une première couche magnétique en replissant les pores d'une première portion de la couche de matériau semi-conducteur poreux avec un premier matériau à haute perméabilité magnétique, la première couche magnétique étant séparée du substrat par une deuxième portion de la couche de matériau semi-conducteur poreux ; et
- former une bobine sur la première couche magnétique.

Dans un mode de mise en œuvre, le procédé de fabrication comprend en outre une étape de gravure de la première couche magnétique de manière à former une cavité annulaire, la bobine étant formée sur la première couche magnétique dans la cavité annulaire.

Dans un autre mode de mise en œuvre, le procédé de fabrication comprend en outre une étape de dépôt d'une deuxième couche magnétique sur la bobine.

La deuxième couche magnétique est de préférence en contact avec la première couche magnétique.

Un troisième aspect de l'invention concerne un dispositif électronique intégré susceptible d'être obtenu par le procédé de fabrication selon le deuxième aspect de l'invention.

Dans un mode de réalisation, le dispositif électronique intégré comprend un composant actif, tel qu'un transistor à grille arrière, situé au même niveau que la couche de matériau semi-conducteur poreux.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1, précédemment décrite, représente une structure multicouche selon l'art antérieur, utilisée comme substrat de départ pour la fabrication de circuits intégrés radiofréquences ;
- la figure 2, précédemment décrite, représente un dispositif électronique intégré selon l'art antérieur, comprenant une bobine sur une couche de silicium poreux ;
- la figure 3 représente un premier mode de réalisation d'un dispositif électronique intégré selon le premier aspect de l'invention ;
- la figure 4 représente un deuxième mode de réalisation du dispositif électronique intégré selon le premier aspect de l'invention ;
- la figure 5 représente un troisième mode de réalisation du dispositif électronique intégré selon le premier aspect de l'invention ;
- la figure 6 représente un quatrième mode de réalisation du dispositif électronique intégré selon le premier aspect de l'invention ;
- les figures 7A à 7D représentent des étapes d'un procédé de fabrication du dispositif électronique intégré selon la figure 3 ;
- les figures 8D et 8E représentent des étapes de fabrication succédant à l'étape de la figure 7C et permettant d'obtenir le dispositif électronique intégré de la figure 4 ; et
- la figure 9F représente une étape supplémentaire de fabrication succédant à l'étape de la figure 8E et permettant d'obtenir le dispositif électronique intégré de la figure 5.

Pour plus de clarté, les éléments identiques ou similaires sont repérés par des signes de référence identiques sur l'ensemble des figures.

### DESCRIPTION DÉTAILLÉE

[Fig. 3] : La figure 3 est une vue schématique en coupe d'un dispositif électronique intégré 30 selon un premier mode de réalisation de l'invention.

Le dispositif électronique intégré 30 comprend un substrat 21, une couche de matériau semi-conducteur poreux 22 disposée sur le substrat 21 et au moins une bobine 23 disposée sur la couche de matériau semi-conducteur poreux 22.

Le substrat 21 (aussi appelé couche de support) est de préférence formé d'un matériau semi-conducteur de haute résistivité, par exemple du silicium haute résistivité. Un matériau semi-conducteur est ici qualifié de haute résistivité lorsque sa résistivité électrique est supérieure ou égale à 1000 Ω.cm. Une telle résistivité permet de réduire les courants de fuite entre les différents composants (actifs ou passifs) formés sur le substrat et les courants de Foucault dans le substrat, limitant ainsi les pertes par effet Joule qui en découlent.

La couche de matériau semi-conducteur poreux 22 présente de préférence une épaisseur comprise entre 0,2 µm et 2 µm. Une telle épaisseur facilite l'intégration du dispositif électronique intégré 30 et réduit le risque de déformation du substrat (phénomène de courbure de plaque appelé « bow » en anglais). Le matériau semi-conducteur poreux est par exemple du silicium poreux ou un alliage silicium-germanium (SiₓGe₁₋x) poreux.

Un matériau à haute perméabilité magnétique 25 est disposé à l'intérieur des pores d'une première portion 22a dite « supérieure » de la couche de matériau semi-conducteur poreux 22. Ce matériau à haute perméabilité magnétique 25 est de préférence un matériau ferromagnétique, par exemple de la ferrite. La ferrite est une céramique ferromagnétique à base d'oxyde de fer qui peut comporter un ou plusieurs autres métaux, tels que le plomb (ferrite de plomb), le manganèse (ferrite de manganèse), le cobalt (ferrite de cobalt) et le nickel (ferrite de nickel).

La porosité du matériau semi-conducteur est avantageusement comprise entre 20 % et 80 %. Plus le degré de porosité est grand, plus il est facile de remplir les pores de matériau à haute perméabilité magnétique, mais plus le matériau semi-conducteur est fragile et le risque de déformation (courbure) du substrat devient grand. Le diamètre des pores est de préférence compris entre 10 nm et 50 nm.

La première portion 22a de la couche de matériau semi-conducteur poreux 22, imprégnée du matériau à haute perméabilité magnétique 25, forme une première couche magnétique. Cette première couche magnétique augmente la valeur d'inductance de la bobine 23, en canalisant une partie des lignes du champ magnétique produit par la bobine 23. Il est par conséquent possible d'obtenir une bobine d'inductance plus élevée pour une même superficie ou de réduire la superficie de la bobine pour une valeur d'inductance donnée.

La première portion 22a de la couche de matériau semi-conducteur poreux 22 est séparée du substrat 21 par une deuxième portion 22b dite « inférieure » de la couche de matériau semi-conducteur poreux 22. Les pores de cette deuxième portion 22b sont dépourvus de matériau électriquement conducteur, en particulier de matériau à haute perméabilité magnétique (les pores du matériau semi-conducteur sont de préférence vides ou remplis d'air). Elle constitue une couche de confinement des électrons, c'est-à-dire une couche dans laquelle le mouvement des électrons est inhibé. La distance sur laquelle les électrons peuvent se déplacer y est très faible, typiquement de l'ordre de la distance entre les pores, soit environ de 10 nm à 50 nm. Les courants de Foucault ne peuvent pas être générés dans la couche de confinement 22, tandis que ceux du substrat 21 sous-jacent restent limités. L'épaisseur de la couche de confinement 22b représente de préférence entre 30 % et 70 % de l'épaisseur de la couche de matériau semi-conducteur poreux 22. A titre d'exemple, l'épaisseur de la couche de confinement 22b est comprise entre 10 nm et 1 µm.

La bobine 23 est de préférence une bobine plane enroulée en spirale. Alternativement, elle peut comporter plusieurs spirales disposées l'une sur l'autre.

La bobine 23 est avantageusement séparée de la première couche magnétique par une couche diélectrique. Cette couche diélectrique empêche les fuites de courant à travers le matériau à haute perméabilité magnétique 25 qui remplit les pores du matériau semi-conducteur poreux. De préférence, la bobine 23 est enrobée d'un matériau diélectrique 24, par exemple du dioxyde de silicium (SiO₂) ou du nitrure de silicium (Si₃N₄). Seuls des via et/ou des lignes d'interconnexion (non représentés sur la figure 3) traversent ce matériau diélectrique 24 pour alimenter la bobine 23 en énergie électrique.

Ainsi, dans ce premier mode de réalisation, la couche de matériau semi-conducteur poreux 22 est divisée dans son épaisseur en deux portions 22a-22b superposées. La première portion 22a imprégnée du matériau à haute perméabilité magnétique 25 forme un circuit magnétique ouvert agencé uniquement sous la bobine 23.

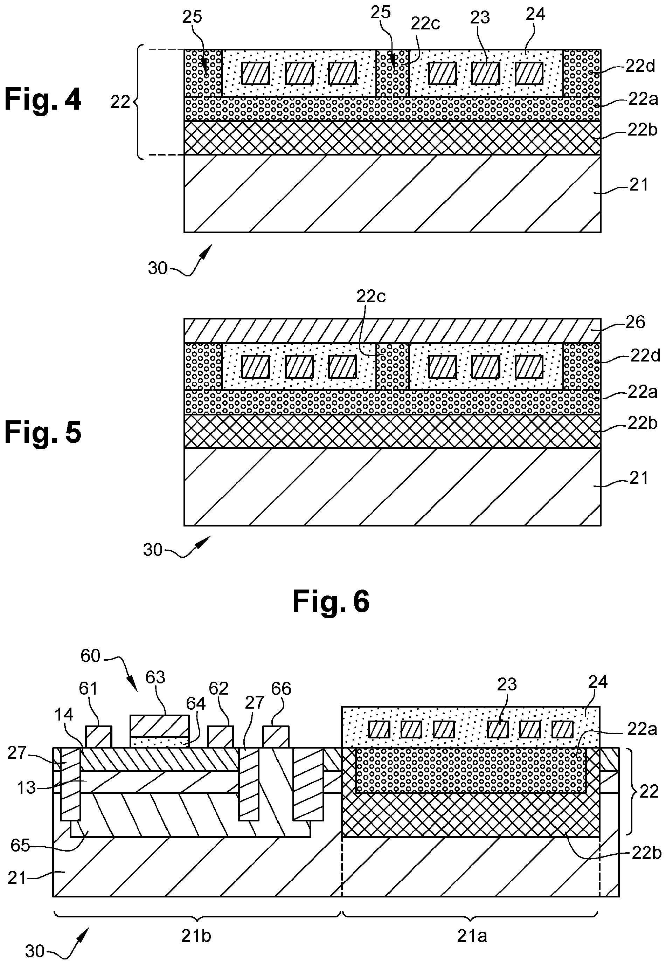

[Fig. 4] : La figure 4 représente un deuxième mode de réalisation du dispositif électronique intégré 30, dans lequel la bobine 23 est enterrée dans la couche de matériau semi-conducteur poreux 22. Le matériau à haute perméabilité magnétique 25 remplit les pores d'une troisième portion 22c de la couche de matériau semi-conducteur poreux 22 située au centre de la bobine 23 et les pores d'une quatrième portion 22d de la couche de matériau semi-conducteur poreux 22 située à la périphérie de la bobine 23. La troisième portion 22c et la quatrième portion 22d imprégnées du matériau à haute perméabilité magnétique 25 forment respectivement un cœur magnétique et un anneau magnétique. Le cœur magnétique et l'anneau magnétique sont ainsi constitués du même matériau « composite » que la première couche magnétique et prolongent la première couche magnétique. Ils pour effet d'augmenter encore plus l'inductance de la bobine 23, en canalisant davantage de lignes de champ. Ils ont de préférence une forme symétrique par rapport à un axe central de la bobine 23.

[Fig. 5] : La figure 5 représente, toujours en vue de coupe schématique, un troisième mode de réalisation du dispositif électronique intégré 30. Ce troisième mode de réalisation diffère du deuxième mode de réalisation (cf. Fig.4) en ce qu'il comprend en outre une deuxième couche magnétique 26 disposée sur la bobine 23. La deuxième couche magnétique 26 forme ainsi avec la première couche magnétique, le cœur magnétique et l'anneau magnétique un circuit magnétique fermé qui entoure entièrement la bobine et passe par son centre. L'inductance de la bobine 23 est ainsi maximisée.

A la différence de la première couche magnétique, qui comprend le matériau semi-conducteur poreux et le matériau à haute perméabilité magnétique 25 disposé à l'intérieur des pores du matériau semi-conducteur poreux, la deuxième couche magnétique 26 peut n'être constituée que de matériau(x) à haute perméabilité magnétique (de préférence un matériau ferromagnétique, tel que de la ferrite). Pour simplifier la fabrication du dispositif électronique intégré 30 (et réduire les coûts de cette fabrication), le matériau à haute perméabilité magnétique de la deuxième couche magnétique 26 et le matériau à haute perméabilité magnétique 25 de la première couche magnétique peuvent être identiques.

[Fig. 6] : Dans un quatrième mode de réalisation représenté par la figure 6, la couche de matériau semi-conducteur poreux 22 et la bobine 23 sont supportées par une première région 21a du substrat 21.

Le substrat 21 peut appartenir à une structure multicouche comprenant (en outre) une couche électriquement isolante 13 disposée sur le substrat 21 et une couche active 14 disposée sur la couche électriquement isolante 13. La couche active 14 est de préférence un film mince de matériau semi-conducteur, intrinsèque ou dopé, par exemple en silicium monocristallin, en germanium, en alliage de silicium-germanium ou en un matériau semi-conducteur III-V. La couche électriquement isolante 13 peut être une couche d'oxyde dite enterrée (car enfouie sous la couche active 14), par exemple en dioxyde de silicium (SiO₂), ou une couche de tout autre matériau diélectrique, par exemple en nitrure de silicium, en un matériau diélectrique « high-k » ou en alumine (Al₂O₃).

Une deuxième région 21b du substrat 21, distincte de la première région 21a, supporte un composant actif, par exemple un transistor MOS à grille arrière 60. On appelle « transistor MOS à grille arrière » un transistor MOS comprenant un canal de conduction, une couche électriquement conductrice séparée du canal de conduction par la couche électriquement isolante, ici la couche d'oxyde enterrée (BOX).

Le transistor MOS 60 comprend un canal de conduction, une région de drain et une région de source, tous les trois formés dans la couche active 14. Le canal de conduction sépare la région de drain et la région de source. Le canal de conduction, la région de drain et la région de source forment ensemble la zone active du transistor, qui peut être délimitée par des tranchées d'isolation peu profondes 27. La couche active 14 est surmontée d'une électrode de drain 61 (en contact avec la région de drain), d'une électrode de source 62 (en contact avec la région de source) et d'une électrode de grille 63. L'électrode de grille 63 est séparée du canal de conduction par un diélectrique de grille 64, typiquement un oxyde.

Le transistor MOS 60 comprend en outre une grille arrière 65, aussi appelée caisson ou plan de masse. La grille arrière 65 est une couche électriquement conductrice qui s'étend au moins en partie sous la couche électriquement isolante 13 (et le canal de conduction du transistor) et qui permet de modifier la tension de seuil du transistor. La grille arrière 65 peut être polarisée à une tension positive ou négative, par exemple grâce à un contact de grille arrière 66 situé au même niveau que les électrodes de drain et de source 61-62. L'épaisseur de la couche électriquement isolante 13 est de préférence inférieure à 30 nm, afin d'optimiser le contrôle électrostatique du canal de conduction par la grille arrière 65.

Le transistor MOS à grille arrière 60 est de préférence de type FDSOI, c'est-à-dire un transistor fonctionnant en mode complètement déplété et fabriqué à partir d'une structure multicouche SOI (silicium sur isolant) comprenant un substrat 21 en silicium de haute résistivité (HR-SOI). L'épaisseur de la couche active 14 est de préférence inférieure à 15 nm.

Sur la figure 6, un seul transistor MOS à grille arrière 60 et une seule bobine 23 ont été représentés. Néanmoins, la première région 21a du substrat 21 peut supporter plusieurs composants passifs (dont au moins une bobine 23) et la deuxième région 21b du substrat 21 peut supporter plusieurs transistors MOS à grille arrière 60, du même type que celui décrit ci-dessus.

Les transistors MOS à grille arrière 60 appartiennent de préférence à un circuit (intégré) logique, par exemple un microprocesseur. Un circuit logique désigne un circuit capable de remplir une ou plusieurs fonctions logiques, par exemple des calculs.

Les composants passifs appartiennent de préférence à un circuit (intégré) radiofréquence (RF), par exemple un module d'émission-réception « front-end ». Ils ont pour but de générer ou traiter (ex. filtrer, amplifier...) des signaux RF. Un circuit RF désigne un circuit capable de remplir une ou plusieurs fonctions de communication (ex : technologies sans-fil Wi-Fi, bluetooth, LTE...).

Ainsi, dans ce dispositif électronique intégré dit « hybride » représenté par la figure 6, la première région 21a du substrat 21 est dédiée à des composants passifs (bobines, capacités, lignes de transmission...) tandis que la deuxième région 21b du substrat 21 est réservée à des composants actifs. Les composants actifs, plus particulièrement les transistors à grille arrière, sont de préférence situés au même niveau que la couche de matériau semi-conducteur poreux 22, c'est-à-dire sur un même plan (autrement dit, à une même hauteur dans une direction perpendiculaire au substrat 21).

D'une façon commune à tous les modes de réalisation, le dispositif électronique intégré 30 peut comporter plusieurs bobines 23 qui partagent un même circuit magnétique (ouvert ou fermé) ou être équipées chacune d'un circuit magnétique distinct. Plusieurs régions distinctes de la couche de matériau semi-conducteur poreux 22 peuvent donc être imprégnées de matériau à haute perméabilité magnétique. Le matériau à haute perméabilité magnétique peut être différent d'une région à l'autre.

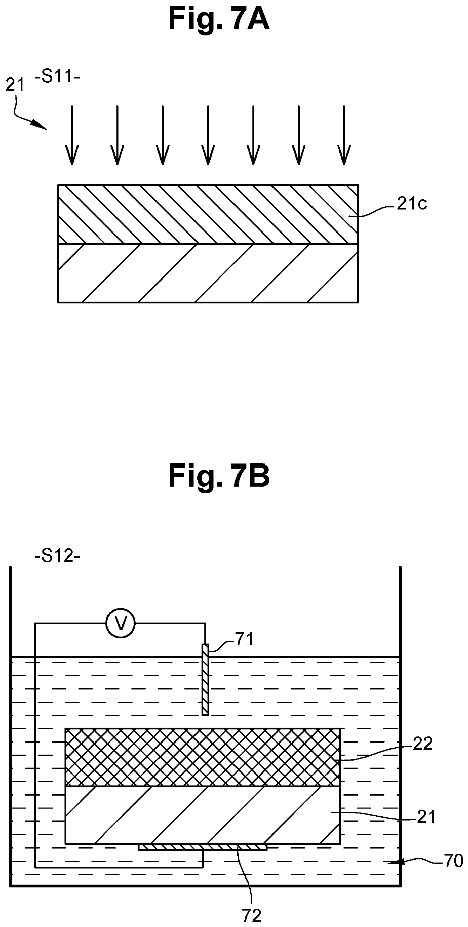

Les figures 7A à 7D illustrent des étapes d'un procédé de fabrication du dispositif électronique intégré 30 selon la figure 3.

La première étape de ce procédé de fabrication consiste à former la couche de matériau semi-conducteur poreux 22 sur le substrat 21.

Dans un mode de mise en œuvre du procédé de fabrication, la formation de la couche de matériau semi-conducteur poreux 22 comprend deux sous-étapes S11 et S12 représentées respectivement par les figures 7A et 7B.

[Fig. 7A] : Lors de la première sous-étape S11, une région superficielle 21c du substrat 21, comprenant la face avant du substrat 21, est dopée de type p ou fortement dopée de type n. Dans le cas d'un dopage de type p, la concentration en impuretés dopantes (ex. atomes de bore) dans la région superficielle 21c est avantageusement supérieure à 10¹⁶ cm⁻³. Dans le cas d'un dopage de type n, la concentration en impuretés dopantes (ex. atomes de phosphore ou d'arsenic) dans la région superficielle 21c est supérieure à 10¹⁸ cm⁻³.

[Fig. 7B] : Puis, lors de la deuxième sous-étape S12, la région superficielle 21c dopée est rendue poreuse par dissolution anodique. La dissolution anodique, aussi appelée anodisation, consiste à plonger le substrat 21 dans un électrolyte 70, par exemple à base d'acide fluorhydrique (HF), tout en appliquant un champ électrique. Le champ électrique peut être généré grâce à deux électrodes : une première électrode 71 plongée dans l'électrolyte 70 et une deuxième électrode 72 en contact avec le substrat 21, par exemple disposée contre la face arrière du substrat 21 (la face arrière se situant à l'opposé de la face avant et donc de la région superficielle 21c). Les autres régions du substrat, qui peuvent être protégées par un masque ou faiblement dopées de type n, ne sont pas impactées par le processus d'anodisation et ne sont donc pas transformées en couches poreuses.

Dans une variante de mise en œuvre non représentée par les figures, une couche de matériau semiconducteur dopé de type p ou fortement dopé de type n est déposée sur le substrat 21, puis rendue poreuse par dissolution anodique.

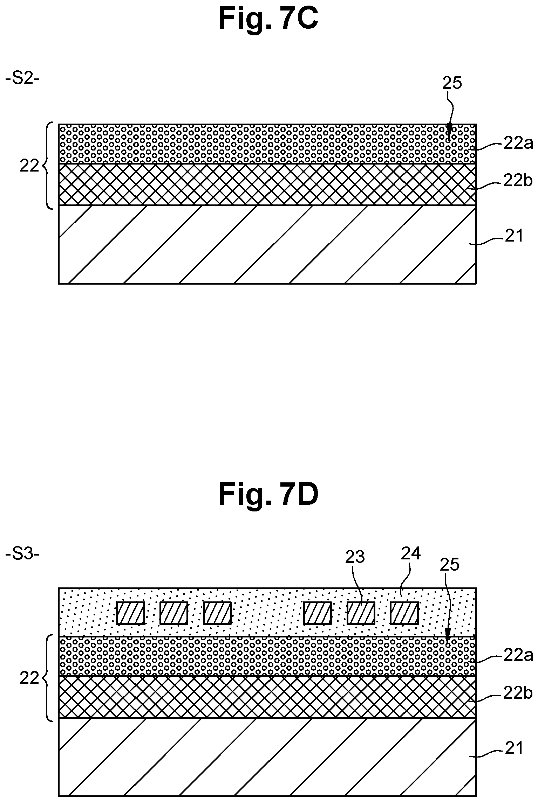

[Fig. 7C] : En référence à la figure 7C, le procédé de fabrication comprend ensuite une étape S2 de formation de la première couche magnétique, par dépôt du matériau à haute perméabilité magnétique 25 dans la première portion 22a de la couche de matériau semi-conducteur poreux 22. Le matériau à haute perméabilité magnétique 25 peut être introduit à l'intérieur des pores du matériau semi-conducteur poreux par électrodéposition ou dépôt de couches atomiques (ALD). L'électrodéposition s'effectue en solution liquide contenant les ions à déposer. En technique ALD, on produit une succession d'impulsions gazeuses contenant des précurseurs qui réagissent chimiquement avec la surface du matériau poreux pour y déposer le composé chimique désiré. Les pores sont de préférence remplis entièrement du matériau à haute perméabilité magnétique 25.

[Fig. 7D] : Enfin, à l'étape S3 de la figure 7D, la bobine 23 est formée sur la première couche magnétique. La formation de la bobine 23 comprend de préférence une sous-étape de dépôt d'une couche métallique et une sous-étape de structuration de la couche métallique, par exemple par photolithographie puis gravure.

La formation de la bobine 23 peut être précédée d'un premier dépôt de matériau diélectrique 24 (ex. SiO₂, Si₃N₄...) et suivie d'un deuxième dépôt de matériau diélectrique 24 (ex. SiO₂, Si₃N₄...), afin d'enrober (ou « encapsuler ») la bobine 23 et l'isoler électriquement de la première couche magnétique.

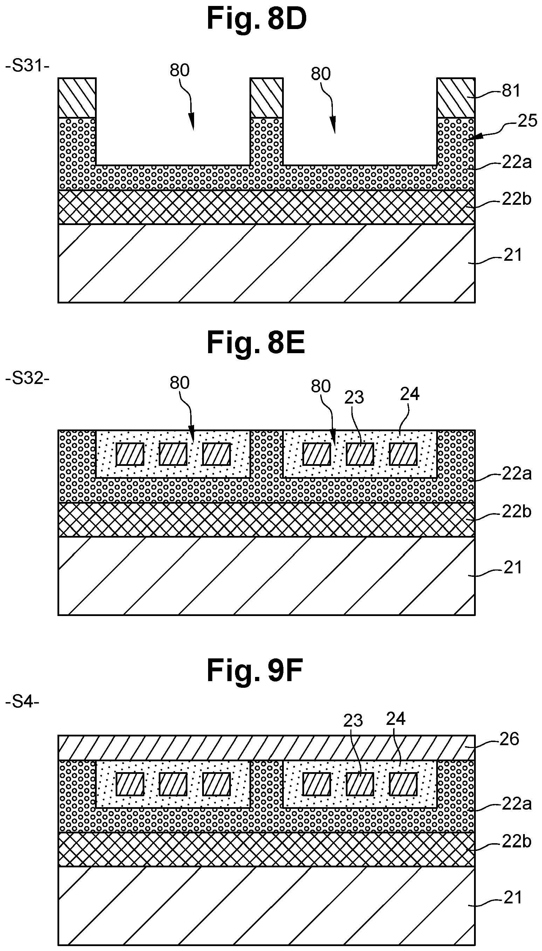

Les figures 8D et 8E représentent des étapes de fabrication S31 et S32 qui, lorsqu'elles remplacent l'étape S3 de la figure 7D, permettent d'obtenir le dispositif électronique intégré 30 de la figure 4.

[Fig. 8D] : L'étape S31 de la figure 8D consiste à graver la première couche magnétique (c'est-à-dire la première portion 22a de la couche de matériau semi-conducteur poreux après son remplissage par le matériau de haute perméabilité magnétique 25), de manière à former une cavité annulaire 80. La gravure peut être accomplie au travers d'un masque 81 comprenant un évidement (i.e. une ouverture) de forme annulaire. La première couche magnétique n'est gravée que sur une partie de son épaisseur. Le fond de la cavité 80 est donc constitué par une portion restante de la première couche magnétique.

[Fig. 8E] : A l'étape S32 de la figure 8E, la bobine 23 est ensuite formée sur la portion restante de la première couche magnétique, à l'intérieur de la cavité annulaire 80. La bobine 23 peut être formée lors de l'étape S32 avant ou après retrait du masque 81, de préférence de la façon décrite en relation avec la figure 7D.

[Fig. 9F] : La figure 9F représente une étape supplémentaire S4 qui peut être accomplie après l'étape S32 de la figure 8E pour obtenir le dispositif électronique intégré 30 de la figure 5 ou après l'étape S3 de la figure 7D. Cette étape supplémentaire S4 consiste à déposer la deuxième couche magnétique 26 sur la bobine 23. La deuxième couche magnétique 26 comprend un deuxième matériau à haute perméabilité magnétique, qui peut être déposé par pulvérisation cathodique, ALD, évaporation par faisceau d'électrons... Les conditions de dépôt du deuxième matériau à haute perméabilité magnétique peuvent être identiques à celles du (premier) matériau à haute perméabilité magnétique 25.

Le procédé de fabrication décrit ci-dessus en relation avec les figures 7 à 9 est simple à mettre en œuvre et facilement industrialisable, car il fait appel à des techniques couramment employées en microélectronique. Il est par ailleurs compatible avec les procédés de fabrication de la technologie CMOS (acronyme de « Complementary Metal Oxide Semiconductor » en anglais).

Ainsi, pour fabriquer le dispositif électronique intégré « hybride » de la figure 6, les étapes décrites précédemment (excepté éventuellement l'étape de dopage de la région superficielle 21c) peuvent être accomplies après la formation du transistor MOS à grille arrière 60 dans la deuxième région 21b du substrat 21, en ayant au préalable recouvert la deuxième région 21b d'un masque dur, par exemple en nitrure de silicium.

La formation du transistor MOS 60 comprend notamment (cf. Fig.6) la formation du caisson ou grille arrière 65 dans la structure multicouche, la formation des tranchées d'isolation peu profondes 27 dans la structure multicouche (afin de délimiter la zone active du transistor dans la couche active 14), la formation d'une structure de grille sur la couche active 14 (la structure de grille comprenant une électrode de grille 63 et un diélectrique de grille 64), le dopage de la couche active pour former des régions de drain et de source (non représentées sur la figure 6), la formation d'une électrode (ou contact) de drain 61, d'une électrode (ou contact) de source 62 et d'un contact de grille arrière 66 sur la couche active 14. La formation du transistor MOS 60 peut également comprendre une étape d'épitaxie sur les régions de drain et de source pour diminuer la résistance des contacts de source et de drain. Les étapes de fabrication d'un transistor MOS à grille arrière (ou double grille) étant connues, elles ne seront pas décrites plus en détail ici.

Le caisson 65 (ou grille arrière) est de préférence formée en implantant des dopants (de type n ou p, selon le type de transistor MOS à fabriquer) dans une partie du substrat 21, à travers la couche électriquement isolante 13 et la couche active 14.

Le dopage de la région superficielle 21c du substrat 21 est avantageusement effectué en même temps, immédiatement avant ou immédiatement après le dopage par implantation ionique du caisson 65. Il peut être avantageux que la région superficielle 21c dopée (destinée à former la couche de matériau semi-conducteur poreux 22) soit plus épaisse que le caisson 65. Les dopants de la région superficielle 21c seront donc implantés plus profondément, par exemple en prévoyant au moins une étape supplémentaire d'implantation ionique ayant un profil d'implantation des dopants différent de celui du caisson 65.

Les étapes de dopage (par exemple par implantation ionique) sont suivies d'une étape de diffusion des dopants. Cette étape de diffusion des dopants s'effectue généralement par recuit, à une température comprise entre 900 °C et 1150 °C. Une telle température pouvant être préjudiciable pour le transistor MOS, les étapes de dopage et de diffusion des dopants du caisson 65 et de la région superficielle 21c sont avantageusement accomplies au début du procédé de fabrication.

Le dispositif électronique intégré et son procédé de fabrication ne sont pas limités aux modes de réalisation décrits ci-dessus en relation avec les figures. De nombreuses variantes et modifications apparaîtront à l'homme du métier. Par exemple, des dispositifs tels que des résistances, des transistors bipolaires ou des diodes de protection ESD (« electrostatic discharge » en anglais) peuvent en outre être fabriqués dans le substrat 21 et d'autres dispositifs tels que des transistors de puissance LDMOS (« Laterally-diffused metal-oxide semiconductor ») peuvent être fabriqués dans la couche active 14.

## Revendications

1. Dispositif électronique (30) comprenant :
- un substrat (21) ;
- une couche de matériau semi-conducteur poreux (22) disposée sur le substrat (21) ;
- un premier matériau à haute perméabilité magnétique (25) disposé à l'intérieur des pores d'une première portion (22a) de la couche de semi-conducteur poreux (22), la première portion (22a) de la couche de matériau semi-conducteur poreux (22) imprégnée du premier matériau à haute perméabilité magnétique (25) formant une première couche magnétique séparée du substrat (21) par une deuxième portion (22b) de la couche de matériau semi-conducteur poreux (22), les pores de la deuxième portion (22b) étant dépourvus de matériau électriquement conducteur ; et
- une bobine (23) disposée sur la première couche magnétique.

2. Dispositif (30) selon la revendication 1, dans lequel la bobine (23) est plane et enroulée en spirale.

3. Dispositif (30) selon l'une des revendications 1 et 2, dans lequel le premier matériau à haute perméabilité magnétique (25) est en outre disposé à l'intérieur des pores d'une troisième portion (22c) de la couche de matériau semi-conducteur poreux (22) et d'une quatrième portion (22d) de la couche de matériau semi-conducteur poreux (22), la troisième portion (21c) étant située au centre de la bobine (23) et la quatrième portion étant située à la périphérie de la bobine (23).

4. Dispositif (30) selon l'une quelconque des revendications 1 à 3, comprenant en outre une deuxième couche magnétique (26) disposée sur la bobine (23), la deuxième couche magnétique (26) comprenant un deuxième matériau à haute perméabilité magnétique.

5. Dispositif (30) selon la revendication 4, dans lequel le premier matériau à haute perméabilité magnétique (25) et le deuxième matériau à haute perméabilité magnétique sont identiques.

6. Dispositif (30) selon l'une quelconque des revendications 1 à 5, dans lequel la couche de matériau semi-conducteur poreux (22) et la bobine (23) sont supportées par une première région (21a) du substrat (21), le dispositif comprenant en outre un composant actif supporté par une deuxième région (21b) du substrat (21), distincte de la première région (21a).

7. Dispositif (30) selon l'une quelconque des revendications 1 à 6, dans lequel la couche de matériau semi-conducteur poreux (22) présente une épaisseur comprise entre 0,2 µm et 2 µm.

8. Dispositif (30) selon l'une quelconque des revendications 1 à 7, dans lequel la deuxième portion (22b) de la couche de matériau semi-conducteur poreux (22) présente une épaisseur comprise entre 10 nm et 1 µm.

9. Dispositif (30) selon l'une quelconque des revendications 1 à 8, dans lequel le substrat (21) est en un matériau semi-conducteur de haute résistivité.

10. Dispositif (30) selon l'une quelconque des revendications 1 à 9, dans lequel les pores de la deuxième portion (22b) sont vides ou remplis d'air.

11. Procédé de fabrication d'un dispositif électronique (30), comprenant les étapes suivantes :
- former (S11, S12) une couche de matériau semi-conducteur poreux (22) sur un substrat (21) ;
- former (S2) une première couche magnétique en replissant les pores d'une première portion (22a) de la couche de matériau semi-conducteur poreux avec un premier matériau à haute perméabilité magnétique (25), la première couche magnétique étant séparée du substrat (21) par une deuxième portion (22b) de la couche de matériau semi-conducteur poreux (22), les pores de la deuxième portion (22b) étant dépourvus de matériau électriquement conducteur ; et
- former (S3, S32) une bobine sur la première couche magnétique.

12. Procédé selon la revendication 11, comprenant en outre une étape (S31) de gravure de la première couche magnétique de manière à former une cavité annulaire (80), la bobine (23) étant formée (S32) sur la première couche magnétique dans la cavité annulaire (80).

13. Procédé selon l'une des revendications 11 et 12, comprenant en outre une étape de dépôt (S4) d'une deuxième couche magnétique (26) sur la bobine (23).
